# EUROPEAN PATENT SPECIFICATION

(11) **EP 3 342 914 B1**
(45) Date of publication and mention of the grant of the patent: **06.10.2021**
(21) Application number: 16207086.6
(22) Date of filing: 28.12.2016
(51) Int. Cl.: D06F 33/00, G01R 31/327, H01H 47/00

(54) **METHOD FOR DIAGNOSING AN ELECTRIC APPLIANCE**
VERFAHREN ZUR DIAGNOSE EINES ELEKTRISCHEN GERÄTES
PROCÉDÉ DE DIAGNOSTIC D'UN APPAREIL ÉLECTRIQUE

(43) Date of publication of application: 04.07.2018
(73) Proprietor: Electrolux Appliances Aktiebolag, 105 45 Stockholm (SE)
(72) Inventor: VITALI, Fabio, 33080 Porcia (IT)
(74) Representative: Electrolux Group Patents

(56) References cited:
- EP-A2- 0 590 545
- US-A1- 2008 089 000
- US-A1- 2012 035 801
- Anonymous: "What should be considered in relay diagnosis", , 28 July 2014 (2014-07-28), XP055388265, Retrieved from the Internet: URL:http://www.elektronikpraxis.vogel.de/e nglish/articles/453995/ [retrieved on 2017-07-05]

## Description

### Field of the invention

The present invention generally relates to electric appliances, such as washing, drying, washing/drying, dishwashing appliances, both for domestic and professional use. More particularly, the present invention relates to a method for diagnosing such electric appliances.

### Background of the invention

Nowadays most of electric appliances, hereinafter appliances, make use of a number of electric loads (such as electric heaters, drain or recirculation pumps, light sources, electric motors, and fans) for performing one or more treatment programs.

In order to allow selective energization and de-energization of the electric loads, each appliance typically comprises a number of electromechanical components (*e.g*., relays) for electrically coupling and decoupling the electric loads to respective supply sources thereby allowing said electric load energization and de-energization, respectively.

According to relay principles of operation, a current flowing through a relay coil actuates (*i.e.,* closes or opens) a pair of relay contacts (thereby causing relay activation or deactivation, respectively).

Relays are typically part, together with a number of electric/electronic components and/or devices, of a circuit system of the appliance. The circuit system is typically formed on a *"Printed Circuit Board",* or PCB, which is supplied by an electronics supplier as a ready-to-mount product to be mounted by the appliance manufacturer at a proper phase of the appliance manufacturing.

Relays are typically the most critical components of the circuit system. Indeed, a missed actuation or a spurious (*i.e.,* undesired) actuation of the relay contacts may impair the whole appliance operation. In order to face this issue, most of known prior-art solutions are based on the common approach of detecting a current (activated or activated) state of the relay during execution of a treatment program.

US 2008/089000 discloses a relay controller for connecting a power source, the relay controller includes at least one relay having at least two contacts, a processing device operable to selectively switch the relay contacts, and a feedback circuit adapted to identify an actual state of the relay contacts. The processing device is configured to recognize a fault contact condition of a disparity between an expected state of the relay contacts and the actual state of the relay contacts. The processing device is also configured to responsively communicate information relating to the relay fault condition. US 2008/089000 discloses the features in the preamble of claim 1.

US 2012/035801 discloses a method and apparatus that diagnose a correct operation of a phase or star point isolation relay in an electric power steering system of the kind including a motor drive circuit and at least one phase isolation relay which connects a part of the drive circuit to a phase of the motor.

### Summary of invention

The Applicant has realized that the known prior-art solutions allow determining relay malfunctioning too late, *i.e.* only after the appliance has been installed in the user premises, and/or temporally too limited and constrained, *i.e.* only during the execution of a treatment program.

The Applicant has also realized that the PCB, and particularly the relays on it, are easily susceptible to damages during shipping and/or to aging caused by usage, so that according to the Applicant the need exists of allowing the appliance manufacturer to easily and reliably determine relay malfunctioning at any suitable phase of the appliance life.

The Applicant has understood that both damages and aging cause uncertainty about an actual driving voltage with which the relay should be driven for controlling activation and deactivation thereof.

Indeed, each relay is typically designed for a fairly specific range of driving voltages. By way of example, for a relay designed to operate at a nominal driving voltage, the actual driving voltage may range from a lower driving voltage, below which the current through the relay coil may be too small to close the relay contacts (or may cause the relay contacts to close intermittently and "chatter"), to a higher driving voltage, above which the increased current through the relay coil may cause overheating or relay coil burn-out. However, the Applicant has noticed that damages and/or usage may affect the electromechanical properties (and, hence, the actual driving voltages) of the relays. According to the Applicant, this uncertainty about the actual driving voltages of the relays makes control of relay activation and deactivation difficult (and, hence, prone to errors), thus impairing appliance operation.

Moreover, each relay typically features (*i.e.,* it is responsive to) different driving voltages for different relay operating states, for example a driving voltage that allows relay activation (or activation driving voltage) in an activation state, and a driving voltage that allows the relay to keep (*i.e.,* to hold) activation (or hold driving voltage) in a hold phase - the hold driving voltage being typically lower than the activation driving voltage, and a voltage below the hold driving voltage determining relay deactivation. This makes uncertainty even more serious.

In view of the above, it is an object of the present invention to provide a method for diagnosing an appliance, and particularly for easily and correctly diagnosing the relays during any suitable phase of the appliance life, such as during appliance manufacturing and/or during appliance servicing.

The present invention is defined in the independent claim 1 with preferred embodiments disclosed in the dependent claims.

An aspect of the present invention relates to a method for diagnosing an electric appliance. The electric appliance comprises at least one electromechanical component each one being switchable between deactivated and activated states for selectively coupling and decoupling electric loads to respective supply sources of the appliance thereby allowing electric load energization and de-energization, respectively, for each selected electromechanical component the method being characterized by comprising:
applying to the selected electromechanical component a PWM signal having a duty cycle whose value is at a reference duty cycle value,
varying the value of duty cycle of the PWM signal from the reference duty cycle value,
sensing the switching of the selected electromechanical component, the value of duty cycle at which the switching of the selected electromechanical component has been sensed corresponding to an actual minimum driving signal to which the selected electromechanical component is responsive,
comparing the actual minimum driving signal of the selected electromechanical component to a respective expected minimum driving signal to which the selected electromechanical component is expected, by design, to be responsive, and
signaling an error of the selected electro-mechanical component if the actual minimum driving signal is higher than the respective expected minimum driving signal.

According to an embodiment, the reference duty cycle value comprises a first reference duty cycle value and the actual minimum driving signal comprises an actual minimum activation driving signal to which the selected electromechanical component is responsive for activation. Additionally or alternatively, said applying comprises applying to the selected electromechanical component a PWM signal having a duty cycle whose value is at the first reference duty cycle value, with the first reference duty cycle value the selected electromechanical component being in the deactivated state. Additionally or alternatively, said varying comprises increasing the value of duty cycle of the PWM signal from the first reference duty cycle value. Additionally or alternatively, said sensing comprises sensing the switching of the selected electromechanical component into the activated state, the value of duty cycle at which the switching of the selected electromechanical component has been sensed corresponding to the actual minimum activation driving signal of the selected electromechanical component. Additionally or alternatively, said comparing comprises comparing the actual minimum activation driving signal of the selected electromechanical component to a respective expected minimum activation driving signal to which the selected electromechanical component is expected, by design, to be responsive, for activation. Additionally or alternatively, said signaling comprises signaling an error of the selected electro-mechanical component if the actual minimum activation driving signal is higher than the respective expected minimum activation driving signal.

According to an embodiment, the reference duty cycle value comprises a second reference duty cycle value, and the actual minimum driving signal comprises an actual minimum hold driving signal at which the selected electromechanical component is still held in the activated state. Additionally or alternatively, said applying comprises applying to the selected electromechanical component a PWM signal having a duty cycle whose value is at the second reference duty cycle value, with the second reference duty cycle value the selected electromechanical component being in the activated state. Additionally or alternatively, said varying comprises decreasing the value of duty cycle of the PWM signal from the second reference duty cycle value. Additionally or alternatively, said sensing comprises sensing the switching of the selected electromechanical component into the deactivated state, the value of duty cycle at which the switching of the selected electromechanical component has been sensed corresponding to the actual minimum hold driving signal of the selected electromechanical component. Additionally or alternatively, said comparing comprises comparing the actual minimum hold driving signal of the selected electromechanical component to a respective expected minimum hold driving signal at which the selected electromechanical component is expected, by design, to be still held in the activated state. Additionally or alternatively, said signaling comprises signaling an error of the selected electro-mechanical component if the actual minimum hold driving signal is higher than the respective expected minimum hold driving signal.

According to an embodiment, said applying to the selected electromechanical component a PWM signal having a duty cycle whose value is at the second reference duty cycle value is carried out after said comparing the actual minimum activation driving signal of the selected electromechanical component to the respective expected minimum activation driving signal.

According to an embodiment, the second duty cycle value is higher than the value of duty cycle corresponding to the actual minimum activation driving signal of the selected electromechanical component.

According to an embodiment, said signaling an error of the selected electromechanical component comprises providing an estimate of a residual lifetime of the selected electromechanical component based on the actual minimum driving signal thereof.

According to an embodiment, said signaling an error of the selected electromechanical component comprises providing an estimate of a residual lifetime of the selected electromechanical component based on at least one between the actual minimum activation driving signal and the actual minimum hold driving signal thereof.

According to an embodiment, said increasing comprises progressively increasing the value of duty cycle of the PWM signal from the first reference duty cycle value. Additionally or alternatively, said sensing the switching of the selected electromechanical component into the activated state is performed at each increase. Additionally or alternatively, the method further comprises repeating said increasing and said sensing until the switching of the selected electromechanical component into the activated state is sensed.

According to an embodiment, said decreasing comprises progressively decreasing the value of duty cycle of the PWM signal from the second reference duty cycle value. Additionally or alternatively, said sensing the switching of the selected electromechanical component into the deactivated state is performed at each decrease. Additionally or alternatively, the method further comprises repeating said decreasing and said sensing until the switching of the selected electromechanical component into the deactivated state is sensed.

According to an embodiment, said signaling an error of the selected electromechanical component comprises displaying an indication of the error and/or emitting sound and/or light alarms.

According to an embodiment, said indication of the error comprises at least one between an alphanumeric code attributable to the error and a message directly describing the error.

According to an embodiment, the method is carried out during a manufacturing process and/or a servicing of the electric appliance.

According to an embodiment, said at least one electromechanical component comprises at least one relay.

According to an embodiment, the electric appliance is a laundry washing appliance, a laundry drying appliance, or a laundry washing/drying appliance.

### Brief description of the annexed drawings

These and other features and advantages of the present invention will be made apparent by the following description of some exemplary and non-limitative embodiments thereof; for its better intelligibility, the following description should be read making reference to the attached drawings, wherein:
**Figure 1** shows a perspective view of an appliance wherein the present invention may be applied;
**Figure 2** schematically shows a portion of a circuit system of the appliance according to an embodiment of the present invention; and
**Figure 3** shows a simplified flowchart of a diagnosis procedure implemented by the circuit system of **Figure 2** according to an embodiment of the present invention.

### Detailed description of preferred embodiments of the invention

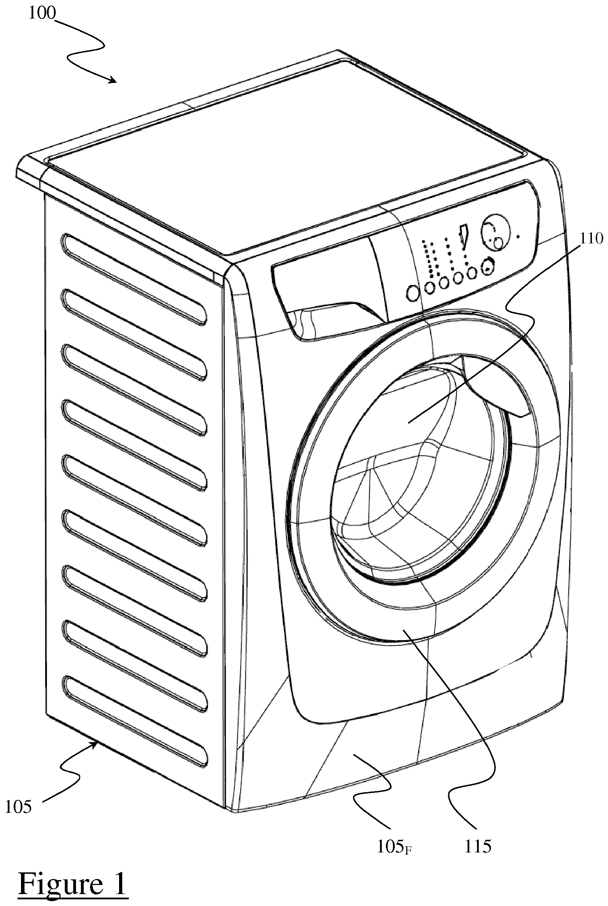

Referring now to the drawings, **Figure 1** schematically shows an electric appliance (or appliance) **100,** for example for domestic use, wherein the present invention may be applied. The appliance **100** may for example be a laundry washing appliance intended to perform laundry washing operations, a laundry drying appliance intended to perform laundry drying operations, or (as herein assumed by way of example only) a laundry washing/drying appliance intended to perform both laundry washing and laundry drying operations. However, as will be better understood from the following description, the present invention lends itself to be applied to any appliance, for domestic or professional treatment of items, making use of one or more electromechanical components.

The appliance **100** preferably comprises a substantially parallepiped-shaped cabinet **105,** which encloses an inner compartment.

In the exemplarily considered appliance **100** (which is intended to perform both laundry washing and laundry drying operations), the inner compartment accommodates a tub (not visible), adapted to be filled with washing liquids, and a (*e.g.,* perforated) rotatable drum **110** mounted therein (in either a horizontal or vertical orientation) adapted to house the laundry to be treated (*i.e.,* the laundry to be washed and/or dried, in the example at issue). Anyway, according to the considered appliance (and, hence, according to the treatment the appliance is intended/designed to perform and the items the appliance is intended/designed to treat), the inner compartment may accommodate, instead of the tub and the rotatable drum **110,** any suitable treatment chamber.

The inner compartment (and the rotatable drum **110**) is accessible through an access door **115** (shown in a closed configuration), preferably provided on a front face **105_{F}** of the cabinet **105** for loading/unloading the laundry.

The inner compartment also accommodates, not visible in such a figure, a number of well-known electronic, electrohydraulic and/or electromechanical components, which form (as a whole) a circuit system that allows running a procedure (hereinafter, diagnosis procedure) for diagnosing the appliance **100** during a manufacturing process and/or a servicing thereof. More particularly, the diagnosis procedure is aimed at determining errors in one or more electromechanical components that typically allow energization/de-energization of electric loads of the appliance **100.** These errors may be due, for example, to breakages and/or damages prior to the purchase of the appliance by a user (indeed, the electromechanical components are typically arranged, together with other components of the circuit system, on a *"Printed Circuit Board",* or PCB, supplied by an electronics supplier as a ready-to-mount product, which could damage during shipping), or to performance decrease over time (*e.g*., aging caused by usage of the appliance by the user). Electromechanical component breakages and/or damages are conveniently determined (*i.e*., the same diagnosis procedure is conveniently run) during the appliance manufacturing, *e.g*. before mounting the PCB inside the appliance **100,** whereas electromechanical component aging is conveniently determined (*i.e.,* the diagnosis procedure is conveniently run) during the appliance servicing.

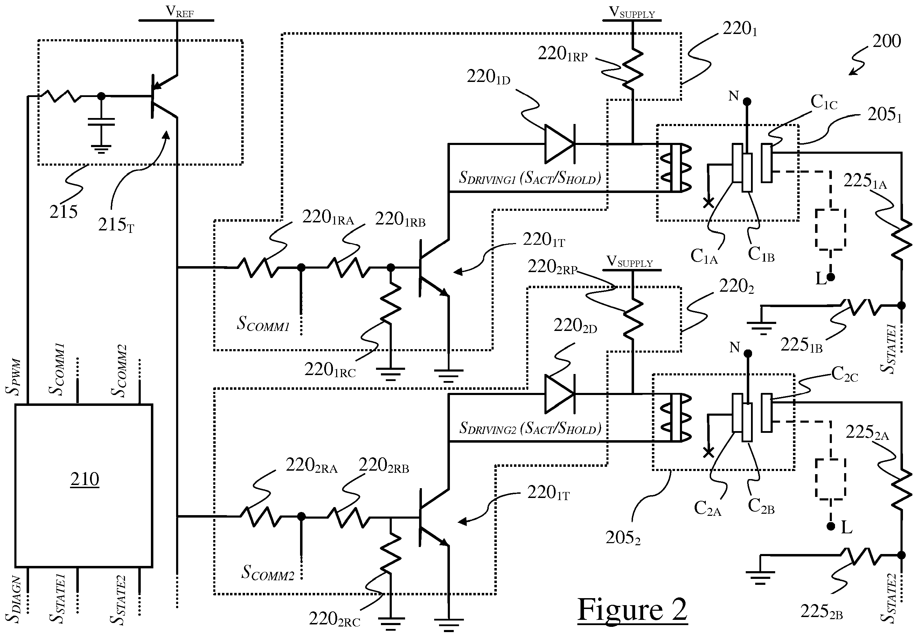

Hereinafter, reference will be made to **Figure 2****,** which schematically shows a portion of a circuit system **200** according to an embodiment of the present invention.

Advantageously, as will be better understood while progressively discussing the circuit system **200,** the same circuit system **200** also allows operating the appliance **100** once it is installed in the user premises, *e.g*., by managing the execution of treatment programs. In other words, the circuit system **200** allows both the execution of treatment programs required by the user, and the running of the diagnosis procedure by the appliance manufacturer when the circumstances so require.

The circuit system **200** is adapted to be coupled, during the manufacturing process, to one or more electric loads. The electric loads are shown in the figures only in dashed lines, as it has been exemplary assumed that the diagnosis procedure is run before coupling between the electric loads and the circuit system **200** takes place - however, the diagnosis procedure can be run at any suitable step of the appliance manufacturing process, such as after coupling between the electric loads and the circuit system **200** has taken place (in which case the circuit system **200** would conceptually include also the electric loads, without substantially any prejudice on the diagnosis procedure principles). Without losing generality, the electric loads may comprise one or more among electric heaters (*e.g.,* for washing liquids and/or drying air heating), drain or recirculation pumps (*e.g.,* for draining or recirculating the washing liquids), light sources (*e.g.,* for visually informing the user about the appliance operation), electric motors (such as electric motors for drum rotation and/or for recirculation pump operation), and fans (*e.g.,* for electric motors cooling).

The circuit system **200** comprises one or more (*e.g.,* two) electromechanical components (*e.g*., relays) **205₁,205₂** for selectively coupling and decoupling the electric loads to respective supply sources of the appliance **100** (thereby allowing electric load energization and de-energization, respectively), a switching arrangement for switching each selected relay **205₁,205₂** between activated and deactivated states thereby allowing said energization and de-energization of the respective electric load, and for keeping the selected relay **205₁,205₂** into an activation holding state after having switched into the activated state.

Each relay **205₁,205₂** may be functionally associated with a respective electric load. This may be advantageous when the electric loads need to be energized (independently) at different steps of a treatment program carried out by the appliance **100,** such as an electric heater and a drain pump (indeed, when the electric heater is energized for heating the washing liquids thereby carrying out a washing step, the drain pump needs to be de-energized; at the end of the washing step, when the drain pump is energized for discharging the washing liquids, the electric heater needs to be de-energized).

Anyway, embodiments may also be provided wherein one or more of the relays are functionally associated each one with a respective plurality of (*i.e.,* two or more) electric loads. This may be advantageous in case of electric loads intended to be energized concurrently at same steps of a treatment program carried out by the appliance **100,** such as an electric heater heating the washing liquids during the washing step and (*e.g.,* a subset of) the light sources indicating the ongoing washing step (indeed, when the electric heater is energized for heating the washing liquids during the washing step, the light sources need to be energized for signaling that; at the end of the washing step, when the electric heater is de-energized, the electric heater needs to be de-energized too, so as to visually signal the user about the end of the washing step).

As mentioned above, the relays **205₁,205₂** are intended to selectively couple and decouple the electric loads to respective supply sources of the appliance **100.** The supply sources may differentiate from each other for supply source type *(e.g.,* DC or AC) and/or value.

In the illustrated, not limiting, embodiment, each relay **205₁,205₂** is arranged for selectively coupling and decoupling the respective electric load to a same supply source. According to an embodiment of the present invention, the supply source is an AC supply voltage from supply terminals (*e.g*., line **L** and neutral **N** terminals) of an AC power supply. For the purposes of the present invention, the line **L** and neutral **N** terminals are connected, respectively, to the electric load and to a relay **205₁,205₂** contact (as better discussed here below); in any case, it should be understood that the line **L** and neutral **N** terminals may also be connected to other portions of the circuit system **200.**

Preferably, as illustrated, the circuit system **200** also comprises a DC supply voltage, hereinafter referred to as supply voltage *V_{SUPPLY},* provided at a supply terminal **V**_{SUPPLY}**.** For example, the supply voltage *V_{SUPPLY}* may be a voltage of 5V, 9V, 12V, 24V, or 48V with respect to a reference voltage (for example a ground voltage *GND, e.g.* 0V) - the terminal providing the ground voltage, or ground terminal, being represented in the figure by its conventional electrical symbol. Although not shown, the supply *V_{SUPPLY}* and ground *GND* voltages are preferably obtained by power conversion of the AC supply voltage from line **L** and neutral **N** terminals of the AC power supply.

Preferably, as illustrated, each relay **205₁,205₂** comprises respective contacts **C_{1A},C_{1B},C_{1C}, C_{2A},C_{2B},C_{2B}** and a relay coil (*e.g.,* a coil of wire wrapped around an iron core) electrically coupled to the switching arrangement.

A central contact of each relay **205₁,205₂,** *e.g.* the contact **C_{1B},C_{2B}** in the figure, is movable with respect to (*i.e.,* it can be actuated towards) the other, or fixed (mechanically separated and electrically insulated) side contacts of the same relay (*i.e.* the side contacts **C_{1A},C_{2A}** and **C_{1C},C_{2C}** in the example at issue).

In the exemplary illustrated embodiment, the side contact **C_{1A},C_{2A}** of each relay **205₁,205₂** is floating, the side contact **C_{1C},C_{2C}** of each relay **205₁,205₂** is electrically coupled to a sensing arrangement (as discussed in the following) - the side contact **C_{1C},C_{2C}** of each relay **205₁,205₂** being intended to be electrically coupled also to the respective electric load. Preferably, the central contact **C_{1B},C_{2B}** is electrically coupled to the neutral terminal **N** of the AC power supply - in any case, according to specific design options, electrical coupling of the central contact **C_{1B},C_{2B}** to other terminals may be envisaged.

In absence of electric current across the relay coil, the central contact **C_{1B},C_{2B}** of each relay **205₁,205₂** is electrically coupled to a respective side contact, *e.g.* the contact **C_{1A},C_{2A}** (and an air gap, and hence electrical insulation, is established between the central contact **C_{1B},C_{2B}** and the opposite side contact **C_{1C},C_{2C}**). When instead an electric current is passed through the relay coil, a magnetic field is generated that enables movement/actuation of the central contact **C_{1B},C_{2B}** from the side contact **C_{1A},C_{2A}** to the respective side contact **C_{1C},C_{2C}** (until mechanical and electrical contacting is established therebetween). Thus, in the considered embodiment, each relay **205₁,205₂** takes a first, deactivated, state wherein the central contact **C_{1B},C_{2B}** contacts the respective side contact **C_{1A},C_{2A}** so that no electrical coupling between the respective electric load and the AC supply voltage takes place (*i.e.,* with the electric load that is not connected to the neutral terminal **N**), and is operable in a second, activated state wherein the central contact **C_{1B},C_{2B}** contacts the respective side contact **C_{1C},C_{2C}** thereby allowing the electrical coupling between the respective electric load and the AC supply voltage (*i.e.,* with the electric load that is connected between the line **L** and neutral **N** terminals).

The switching arrangement comprises a driving arrangement (discussed here below) for driving each selected relay **205₁,205₂** with a respective driving signal *S_{DRIVING1},S_{DRIVING2}* (*e.g.,* a driving voltage that results in an electric current across the relay coil), and a PWM generator arranged for generating a *"Pulse-Width Modulated"* signal (hereinafter, PWM signal) *S_{PWM}* (or for generating any other signal, either voltage or current signal, whose average value can be modulated, *i.e.* dynamically adjusted), and for feeding it to the driving arrangement. The driving arrangement is in turn configured to feed each selected relay **205₁,205₂** with the respective driving signal *S_{DRIVING1},S_{DRIVING2}* derived from the PWM signal *S_{PWM}.*

The PWM generator function may for example be accomplished by a dedicated unit (not shown) or, as in the exemplary illustrated embodiment, by (a suitable section of) a control unit **210** (for example, a microcontroller/microprocessor), the PWM signal *S_{PWM}* being for example output from a suitable pin (hereinafter referred to as PWM pin) of the control unit **210.**

The control unit **210** is preferably intended to manage the whole appliance operation; however, for the sake of conciseness, only aspects/functionalities of the control unit **210** relevant for the present invention will be introduced and discussed in the following.

As better discussed in the following, the control unit **210** is also configured to control the driving arrangement operation in the context of the diagnosis procedure, *e.g,* as well as during normal operation of the appliance (*e.g.,* execution of treatment programs). Preferably, the diagnosis procedure is carried out by the control unit **210** upon reception (*e.g.,* from an external test equipment, not shown) of a diagnosis enabling signal *S_{DIAGN}* at a suitable pin (hereinafter referred to as diagnosis pin) of the control unit **210.**

During execution of a treatment program, under the control of the control unit **210,** the PWM signal *S_{PWM}* has a duty cycle whose value allows the relay **205₁,205₂** to be switched into the activated state from the deactivated state (hereinafter referred to as activation duty cycle value), and a duty cycle whose value, *e.g*. lower than the activation duty cycle value, allows the relay **205₁,205₂** to be held in the activated state after switching from the deactivated state to the activated state has taken place (hereinafter referred to as hold duty cycle value). As will be understood from the following description, the ability of the control unit **210** to change the value of duty cycle of the PWM signal *S_{PWM}* is conveniently exploited also in the diagnosis procedure.

According to pulse-width modulation principles, the average value of the electric voltage (and current) fed to the relay coil is controlled by powering and unpowering it at a fast rate - the longer the powering time with respect to the unpowering time over a certain time period, the higher the total power supplied to the relay coil. In this context, the term duty cycle denotes the proportion (*e.g.,* expressed in percent) of the powering time to the time period, so that low and high duty cycle values correspond, respectively, to low and high powers fed to the relay coil.

The PWM signal *S_{PWM}* whose duty cycle is at the activation or hold duty cycle values determine respective average values of the corresponding driving signal *S_{DRIVING1},S_{DRIVING2}* across the relay coils, these average values being referred to as activation *S_{ACT}* or hold *S_{HOLD}* driving signals, respectively (*i.e.,* each driving signal *S_{DRIVING1},S_{DRIVING2}* may result, depending on the value of duty cycle of the PWM signal *S_{PWM},* in a respective activation *SACT* or hold *SHOLD* driving signals, as also conceptually represented in the figure by *S_{ACT}*/*S_{HOLD}* associated with each driving signal *S_{DRIVING1},S_{DRIVING2}*). This is inspired by the feature of most of known relays to hold the activated state with a hold driving signal that (nominally, *i.e.* malfunctioning aside) is lower than the activation driving signal.

Preferably, as herein exemplary discussed, the driving arrangement is configured to selectively feed each selected relay **205₁,205₂** with same activation *S_{ACT}* and hold *S_{HOLD}* driving signals derived from the same PWM signal *S_{PWM}.* Anyway, a PWM signal *S_{PWM}* and/or activation *S_{ACT}* and hold *S_{HOLD}* driving signals different (*e.g.,* for type and/or value) for each relay **205₁,205₂** (or for each set of one or more relays) might also be provided (*e.g*., according to electromechanical properties of the relay/relays **205₁,205₂** to be driven).

Preferably, as visible in the figure, the driving arrangement comprises a number of relay coil drivers. More preferably, the relay coil drivers comprise a shared relay coil driver **215** arranged for receiving the PWM signal *S_{PWM},* and a number of (*e.g.,* two in the example at issue) dedicated relay coil drivers **220₁,220₂** each one electrically coupled to the shared relay coil driver **215** - as should be readily understood, in embodiments of the present invention wherein two or more electric loads are intended to be driven together, a different number of dedicated relay coil drivers as compared to the number of electric loads may be envisaged. The shared relay coil driver **215** defines, together with each dedicated relay coil driver **220₁,220₂,** a two-stage section of the circuit system **200** aimed at providing the activation *S_{ACT}* and hold *S_{HOLD}* driving signals across the respective relay coil thereby allowing activation and activation holding, respectively, of the relay **205₁,205₂.**

As visible in the figure, each dedicated relay coil driver **220₁,220₂** is also arranged to receive a respective command signal *S_{COMM1}*,*S_{COMM2}*, preferably from a respective pin (hereinafter, command pin) of the control unit **210** - as better discussed in the following, each command signal *S_{COMM1},S_{COMM2}* allows commanding the activation, the activation holding or the deactivation of a respective relay **205₁,205₂.** According to an embodiment of the present invention, the command signal *S_{COMM1},S_{COMM2}* can take a high logic level (*e.g.,* associated with the supply voltage *V_{SUPPLY}*)*,* or a low logic level (*e.g.,* associated with the ground voltage, and resulting in a low-impedance state of the corresponding command pin), or a tristate logic level (*e.g.,* corresponding to a high impedance of the respective command pin).

According to the principles of the present invention, the switching arrangement is arranged for switching the relay **205₁,205₂** according to a combination between the command signal *S_{COMM1},S_{COMM2}* and the PWM signal *S_{PWM}.* Broadly speaking, the duty cycle of the PWM signal *S_{PWM}* is such that:
- at a first level of the command signal *S_{COMM1},S_{COMM2} (e.g.* the high logic level or the tristate level, according to different embodiments discussed below), the PWM signal *S_{PWM}* combined with the command signal *S_{COMM1},S_{COMM2}* results in a driving signal at the relay **205₁,205₂** at least equal to the activation driving signal *S_{ACT},* whereby the relay **205₁,205₂** is switched into the activated state;
- at a second level of the command signal *S_{COMM1},S_{COMM2}* (*e.g.* the tristate level) the PWM signal *S_{PWM}* combined with the command signal *S_{COMM1},S_{COMM2}* results in a driving voltage at the relay **205₁,205₂** between said activation *S_{ACT}* and hold *S_{HOLD}* driving signal (*i.e.,* at least equal to the hold driving signal *S_{HOLD}* and lower than the activation driving signal *S_{ACT}*)*,* whereby the relay **205₁,205₂** is held in the activated state, and preferably
- at a third level of the command signal *S_{COMM1},S_{COMM2}* (*e.g.* the low-logic level in the preferred implementation of the driving arrangement), the PWM signal *S_{PWM}* is prevented from being fed to the relay **205₁,205₂,** whereby the relay **205₁,205₂** is switched into the deactivated state.

According to an embodiment of the present invention, the shared relay coil driver **215** comprises a *"Bipolar Junction Transistor"* (BJT) transistor (hereinafter, shared transistor) **215_{T}**, for example in "common emitter" configuration. In this configuration, the emitter terminal of the shared transistor **215_{T}** is electrically coupled to a reference terminal **V_{REF}** providing a reference voltage *V_{REF}* (for example, 3-5V with respect to the ground voltage *GND*), the gate terminal of the BJT transistor **215_{T}** is electrically coupled to the PWM pin of the control unit **210** for receiving the PWM signal *S_{PWM}* (or, in the considered advantageous example, a filtered version thereof), and the collector terminal of the shared transistor **215_{T}** is electrically coupled to the dedicated relay coil driver **220₁,220₂.**

As just mentioned, a filtering arrangement is provided between the gate terminal of the shared transistor **215_{T}** and the PWM pin of the control unit 210 for suppressing possible disturbances from (*i.e.,* associated with) the PWM signal *S_{PWM}.* Preferably, the filter arrangement comprises a low-pass filter, for example a passive low-pass filter. Even more preferably, as illustrated, the low-pass filter is a low-pass RC filter.

According to an embodiment of the present invention, each dedicated relay coil driver **220₁,220₂** comprises a BJT transistor (hereinafter, dedicated transistor) **220_{1T}**,**220_{2T}**, for example in "common emitter" configuration. In this configuration, the emitter terminal of the dedicated transistor **220_{1T},220_{2T}** is electrically coupled to the ground terminal, the gate terminal of the dedicated transistor **220_{1T},220_{2T}** is electrically coupled to the collector terminal of the shared transistor **215_{T}** *(e.g.* by means of a resistive network, as discussed below), and the collector terminal of the dedicated transistor **220_{1T},220_{2T}** is electrically coupled to a first end of the respective relay coil. The second, opposite end of each relay coil is instead electrically coupled to the supply terminal **V_{SUPPLY}** (*e.g*., by interposition of one or more current-limiting components, such as the current-limiting resistor **220_{1RP},220_{2RP}**, for limiting the electric current across the relay coil to a predefined upper limit).

Preferably, as illustrated, the second end of each relay coil is also electrically coupled to the collector terminal of the dedicated transistor **220_{1T},220_{2T}** by interposition of one or more protection components. Even more preferably, the protection components comprise one (as illustrated) or more so called freewheeling diodes, such as the freewheeling diode **220_{1D},220_{2D}**, aimed at protecting the relay coil against large and destructive voltage spikes (indeed, the freewheeling diode **220_{1D},220_{2D}** takes the energy stored in the relay coil when the electric current across it is switched off; without it, the energy would have no place to go and will cause voltage spikes).

Preferably, as illustrated, each dedicated relay coil driver **220₁,220₂** comprises a coupling network, for example a resistive coupling network, for electrically coupling the gate terminal of the dedicated transistor **220_{1T},220_{2T}** to the collector terminal of the shared transistor **215_{T}**. According to the illustrated embodiment, the resistive coupling network comprises first **220_{1RA},220_{2RA}**, second **220_{1RB},220_{2RB}** and third **220_{1RC},220_{2RC}** resistors (hereinafter referred to as first **220_{1RA},220_{2RA}**, second **220_{1RB},220_{2RB}** and third **220_{1RC},220_{2RC}** coupling resistors). In any case, the first **225_{1RA},225_{2RA}**, second **225_{1RB},225z_{RB}** and third **225_{1RC},225_{2RC}** coupling resistors may be replaced, at least in part, by other suitable coupling elements (*e.g*., capacitive and/or inductive coupling elements).

The first coupling resistor **220_{1RA},220_{2RA}** has a first terminal electrically coupled (*e.g.,* directly coupled) to the collector terminal of the shared transistor **215_{T}** and a second terminal electrically coupled to the command pin of the control unit **210** providing the command signal *S_{COMM1},S_{COMM2}.* The second coupling resistor **220_{1RB},220_{2RB}** has a first terminal electrically coupled (*e.g.,* directly coupled) to the second terminal of the first coupling resistor **220_{1RA}**,**220_{2RA}** (and, hence, electrically coupled to the command pin for receiving the command signal *S_{COMM1},S_{COMM2}*) and a second terminal electrically coupled (*e.g.,* directly coupled) to the base terminal of the dedicated transistor **220_{1T},220_{2T}**. The third coupling resistor **220_{1RC},220_{2RC}** has a first terminal electrically coupled (*e.g.,* directly coupled) to the second terminal of the second coupling resistor **220_{1RB},220_{2RB}** (and, hence, electrically coupled to the base terminal of the dedicated transistor **220_{1T},220_{2T}**) and a second terminal electrically coupled to the ground terminal.

As better understood while progressively discussing the operation of the circuit system **200**, provision of the first **220_{1RA},220_{2RA}**, second **220_{1RB},220_{2RB}** and third **220_{1RC},220_{2RC}** coupling resistors allows or excludes combination (*i.e.,* superimposition) of the PWM signal *S_{PWM}* with the command signal *S_{COMM1}*,*S_{COMM2}* order to obtain, respectively, the driving signals *S_{DRIVING1}*,*S_{DRIVING2}* (either activation *S_{ACT}* or hold *S_{HOLD}* driving signal) or no driving signal.

In order to summarize the operation of the circuit system **200** so far discussed, both the operation during the execution of a treatment program and the operation during running of the diagnosis procedure will be taken into consideration - both of them being based on the capability of the control unit **210** of changing the value duty cycle of the PWM signal *S_{PWM}* according to the sensed state of the relay **205₁,205₂.**

### Execution of a treatment program

In the following, reference will be made to two main (not limitative) embodiments for the driving of the relay **205₁,205₂** (hereinafter referred to as first and second driving embodiments). As discussed below, the first and second driving embodiments differ from each other for the combinations of the PWM signal *S_{PWM}* with the command signal *S_{COMM1},S_{COMM2}* used for managing the (activation, deactivation or holding) of the relay **205₁,205₂.**

According to the first driving embodiment, the PWM signal *S_{PWM}* is set at the hold duty cycle for both activation and activation holding of the relay **205₁,205₂.**

More particularly, according to this embodiment:
- in order to switch the relay **205₁,205₂** into the activated state, the command signal *S_{COMM1},S_{COMM2}* is set at the high logic level and the PWM signal *S_{PWM}* is set at the hold duty cycle. In this way, the PWM signal *SPWM* combined with the command signal *S_{COMM1}*,*S_{COMM2}* at the high logic level results in a driving signal at the relay **205₁,205₂** at least equal to the activation driving signal *S_{ACT}* (due to the shifting effect of the command signal *S_{COMM1},S_{COMM2}* on the PWM signal *S_{PWM}*)*.* The use of the PWM signal *S_{PWM}* set at the hold duty cycle allows reducing the energy/power consumption required to switch the relay **205₁,205₂** into the activated state (indeed, the high logic level of the command signal *S_{COMM1},S_{COMM2}* advantageously acts for a short period of time, *e.g.* for the period of time strictly required to switch the relay **205₁,205₂** into the activated state, such that the power consumption given by the combination of the PWM signal *S_{PWM}* with the command signal *S_{COMM1},S_{COMM2}* is certainly lower than that given by the direct application of signal equal to the activation driving signal, as in the known solutions);
- in order to hold the relay **205₁,205₂** in the activated state, the command signal *S_{COMM1},S_{COMM2}* takes the tristate level (with the PWM signal *S_{PWM}* that is kept at the hold duty cycle). In this way, the PWM signal *V_{PWM}* results in a driving signal at the relay **205₁,205₂** equal to the hold driving signal *S_{HOLD}* (indeed, in this case, the PWM signal is passed to the relay **205₁,205₂** substantially unaffected by the command signal *S_{COMM1},S_{COMM2}*). In any case, in alternative embodiments, the PWM signal *S_{PWM}* at the hold duty cycle could result in a driving voltage at the relay **205₁,205₂** between the hold and activation driving signals, according to the specific circuit implementation and/or to the PWM signal *S_{PWM}* setting or sizing, and/or to the logic level of the command signal *S_{COMM1},S_{COMM2} (e.g.,* in case that the first logic level is a voltage level between the high and low logic levels). The use of the PWM signal *S_{PWM}* set at the hold duty cycle allows reducing the energy/power consumption required to keep the relay **205₁,205₂** into the activated state (indeed, the power consumption given by the PWM signal *S_{PWM}* at the hold duty cycle is certainly lower than that given by the direct application of a driving signal equal to the hold driving signal, as in the known solutions);
- in order to switch the relay **205₁,205₂** into the deactivated state, the command signal *S_{COMM1},S_{COMM2}* is set at the low logic level. In this way, irrespective of the duty cycle of the PWM signal *S_{PWM},* the PWM signal *S_{PWM}* is prevented from being fed to the relay **205₁,205₂.** In this way, selective deactivation of each relay **205₁,205₂** can be achieved.

According to the second driving embodiment, the PWM signal *S_{PWM}* is set at the activation duty cycle for activation of the relay **205₁,205₂** and at the hold duty cycle for activation holding of the relay **205₁,205₂.**

More particularly, according to this embodiment:
- in order to switch the relay **205₁,205₂** into the activated state, the command signal *S_{COMM1},S_{COMM2}* is set at the tristate level and the PWM signal *S_{PWM}* is set at the activation duty cycle. In this way, the PWM signal *S_{PWM}* results in a driving signal at the relay **205₁,205₂** equal to the activation driving signal (indeed, in this case, the PWM signal is passed to the relay **205₁,205₂** substantially unaffected by the command signal *S_{COMM1},S_{COMM2}*) or, in any case, above the activation driving signal (depending on the specific circuit implementation and/or on the PWM signal *S_{PWM}* setting or sizing). The use of the PWM signal *S_{PWM}* set at the activation duty cycle allows reducing the energy/power consumption required to switch the relay **205₁,205₂** into the activated state with respect to that given by the direct application of a driving signal equal to the activation driving signal *S_{ACT},* as in the known solutions). With respect to the previous embodiment, which makes use of the PWM signal *S_{PWM}* at the hold duty cycle and of the command signal *S_{COMM1},S_{COMM2}* at the high logic level, a substantially equal power consumption may be assumed (indeed, in the present embodiment, the command signal *S_{COMM1},S_{COMM2}* adds no contribution to power consumption, differently from the first driving embodiment);
- in order to hold the relay **205₁,205₂** in the activated state, the PWM signal *S_{PWM}* is set with the hold duty cycle (with the command signal *S_{COMM1},S_{COMM2}* that is kept at the tristate level). In this way, the PWM signal *S_{PWM}* results in a driving signal at the relay **205₁,205₂** equal to the hold driving voltage (indeed, in this case, the PWM signal *S_{PWM}* is passed to the relay **205₁,205₂** substantially unaffected by the command signal *S_{COMM1},S_{COMM2}*) or, in any case, between the hold and activation driving signals (depending on the specific circuit implementation and/or on the PWM signal *S_{PWM}* setting or sizing). As discussed for the first driving embodiment, the use of the PWM signal *S_{PWM}* set at the hold duty cycle allows reducing the energy/power consumption required to keep the relay **205₁,205₂** into the activated state (indeed, the power consumption given by the PWM signal *S_{PWM}* at the hold duty cycle is certainly lower than that given by the direct application of a driving signal equal to the hold driving signal, as in the known solutions);
- in order to switch the relay **205₁,205₂** into the deactivated state, the command signal *S_{COMM1},S_{COMM2}* is set at the low logic level. In this way, irrespective of the duty cycle of the PWM signal *S_{PWM},* the PWM signal *S_{PWM}* is prevented from being fed to the relay **205₁,205₂.** In this way, selective deactivation of each relay **205₁,205₂** can be achieved.

As should be understood, the effects of the high and low logic levels and of the tristate level on the relay **205₁,205₂** discussed in connection with the above first and second driving embodiments are merely indicative and derive from the exemplary practical implementation of the shared **215** and dedicated **220₁,220₂** relay coil drivers discussed here below.

### Diagnosis Procedure

The first and second driving embodiments related to the combinations of the PWM signal *S_{PWM}* and of the command signal *S_{COMM1},S_{COMM2}* for managing the (activation, deactivation or activation holding) of the relay **205₁,205₂** discussed above in connection with the execution of the treatment program also apply to the running of the diagnosis procedure, as will be apparent from the following discussion. In any case, in the following discussion, the first driving embodiment will be exemplary assumed (with the second driving embodiment that will be instead cited in brackets), and with the effects of the various combinations of the PWM signal *S_{PWM}* and of the command signal *S_{COMM1},S_{COMM2}* that will not be repeated for the sake of conciseness.

During the running of the diagnosis procedure, when the relay **205₁,205₂** has to be switched from the deactivated state to the activated state in order to identify an actual activation duty cycle value (and, hence, an actual minimum activation driving signal) to which the relay **205₁,205₂** is responsive, the control unit **210** sets the command signal *S_{COMM1},S_{COMM2}* at the high logic level (or at the tristate level) and the duty cycle of the PWM signal *S_{PWM}* at a first reference duty cycle value. The first reference duty cycle value is such that the superimposition of the PWM signal *S_{PWM}* (*i.e.,* of a derivative thereof resulting from low-pass filtering and shared transistor **215_{T}** processing) with the high logic level, *i.e.* with a derivative thereof resulting from its partition over the second **220_{1RB},220_{2RB}** and third **220_{1RC},220_{2RC}** coupling resistors, (or with the tristate level) is not able to switch the relay **205₁,205₂** into the activated state. Thereafter, the control unit **210** is configured to (*e.g*., progressively) increase the value of duty cycle of the PWM signal *S_{PWM}* from the first reference duty cycle value, such that as soon as the switching of the relay **205₁,205₂** into the activated state is sensed (by means of the sensing arrangement discussed in the following), the value of duty cycle at which the switching has been sensed is identified as the actual activation duty cycle value (corresponding to the actual minimum activation driving signal) to which the relay **205₁,205₂** is responsive.

When the relay **205₁,205₂** has to be switched from the activated state to the deactivated state in order to identify the actual hold duty cycle value (and, hence, the actual minimum hold driving signal) to which the relay **205₁,205₂** is responsive, the control unit **210** sets the corresponding command signal *S_{COMM1},S_{COMM2}* at the tristate logic level (regardless of the considered driving embodiment) and the value of duty cycle of the PWM signal *S_{PWM}* at a second reference duty cycle value. The second reference duty cycle value of the PWM signal *S_{PWM}* is such that the relay **205₁,205₂** is in the activated state (*i.e.,* central contact **C_{1B},C_{2B}** of the relay **205₁,205₂** held in contact with the respective side contact C_{1C},C_{2C}). Thereafter, the control unit **210** is configured to (*e.g*., progressively) decrease the value of duty cycle of the PWM signal *S_{PWM}* from the second reference duty cycle value, such that as soon as the switching of the relay **205₁,205₂** into the deactivated state is sensed (by means of the sensing arrangement discussed in the following), the value of duty cycle at which the switching has been sensed is identified as the actual hold duty cycle value (corresponding to the actual minimum hold driving signal) to which the relay **205₁,205₂** is responsive.

When instead the relay **205₁,205₂** has to be switched into the deactivated state in order to deselect that relay **205₁,205₂,** the control unit **210** sets the corresponding command signal *S_{COMM1},S_{COMM2}* at the low logic level (regardless of the considered driving embodiment). The low logic level generates a low-impedance path that strongly reduces the passage of the PWM signal *S_{PWM}* (*i.e.,* of the derivative thereof resulting from low-pass filtering and shared transistor **215_{T}** processing) across the dedicated transistor **220_{1T},220_{2T},** and hence across the relay coil. This induces the relay coil de-energization, which causes the central contact **C_{1B},C_{2B}** of the relay **210₁,210₂** to get back to its rest (de-actuated) position (*i.e.,* in contact with the respective side contact **C_{1A},C_{2A}**).

Back to **Figure 2****,** as mentioned above, the circuit system **200** also comprises a sensing arrangement electrically coupled to the side contact **C_{1C},C_{2C}** of the relay **205₁,205₂.** Broadly speaking, the sensing arrangement is configured for sensing the activated or deactivated states of the relay **205₁,205₂** and for providing a corresponding signal (hereinafter, state signal) *S_{STATE1},S_{STATE2}* to a corresponding pin (hereinafter, sensing pin) of the control unit **210** - in response to that, the control unit **210** commands the activation or the activation holding by means of the command signals *S_{COMM1},S_{COMM2},* as mentioned above.

Preferably, as illustrated, the sensing arrangement comprises a resistive sensing network between the side contact **C_{1C},C_{2C}** of the relay **205₁,205₂** and the sensing pin of the control unit **210.**

Even more preferably, the sensing arrangement comprises a first sensing resistor **225_{1A},225_{2A}** having a first terminal electrically coupled to the side contact **C_{1C},C_{2C}** of the relay **205₁,205₂** and a second terminal coupled to the respective sensing pin of the control unit **210,** and a second sensing resistor **225_{1B},225_{2B}** having a first terminal electrically coupled to the second terminal of the first sensing resistor **225_{1A},225_{2A}** (and, hence, to the respective sensing pin of the control unit **210**) and a second terminal electrically coupled to the ground terminal.

In this configuration, which is not limiting for the present invention, each state signal *S_{STATE1},S_{STATE2}* can take two different levels according to the relay states, namely a low level S_{STATE,L} equal to the ground voltage *GND* when the relay **205₁,205₂** is deactivated (indeed, in such a condition, the side contact **C_{1C},C_{2C}** of the relay **205₁,205₂** is floating, and any voltage on it is forced down to the ground voltage *GND* by pull-down effect of the first **225_{1A},225_{2A}** and second **225_{1B},225_{2B}** sensing resistors), and a high level S_{STATE,H} higher than the low level S_{STATE,L} (indeed, in such a condition, the side contact **C_{1C},C_{2C}** of the relay **205₁,205₂** is electrically coupled to the neutral terminal **N,** and a partition of the voltage at the neutral terminal **N** on the first **225_{1A},225_{2A}** and second **225_{1B},225_{2B}** sensing resistors takes place).

As better discussed here below, during the execution of a treatment program (or, in the context of, such as before or after, the execution of the treatment program), in response to the state signal *S_{STATE1},S_{STATE2}* the control unit **210** is configured to change at least one between the activation and the hold duty cycles values (and, hence, the activation *S_{ACT}* and hold *S_{HOLD}* driving signals applied to the relay **205₁,205₂**), whereas during the running of the diagnosis procedure the control unit **210** is configured to vary (*e.g*., increase or decrease) the value of duty cycle of the PWM signal *S_{PWM}* from the (first or second) reference duty cycle values.

This is summarized here below for each case:

### Execution of a treatment program

During the execution of a treatment program, the control unit **210** is configured to increase the activation duty cycle value of the PWM signal *S_{PWM}* if, during sensing, the duty cycle of the PWM signal *S_{PWM}* is at the activation duty cycle value and the selected relay **205₁** and/or **205₂** is in the deactivated state (*S_{STATE1}*=S_{STATE,L} and/or S*_{STATE2}*=S_{STATE,L}, respectively). In other words, the control unit **210** is configured to increase the activation duty cycle value if the current activation duty cycle value (and, hence, the current activation driving signal *S_{ACT}*) is insufficient to activate the selected relay **205₁,205₂** (*e.g.,* because of an altered voltage responsivity of relay **205₁,205₂** due, for example, to relay **205₁,205₂** malfunctioning and/or wearing).

Additionally or alternatively, the control unit **210** may be configured to increase the hold duty cycle value if, during sensing, the duty cycle of the PWM signal *S_{PWM}* is at the hold duty cycle value and the selected relay **205₁,205₂** is in the deactivated state (S*_{STATE1}*=S_{STATE,H} and/or S*_{STATE2}*=S_{STATE,H}, respectively). In other words, the control unit **210** is configured to increase the hold duty cycle value if, after relay **205₁,205₂** activation, the current hold duty cycle value (and, hence, the corresponding current hold driving signal *S_{HOLD}*) is insufficient to keep the relay **205₁,205₂** in the activated state (*e.g*., because of an altered voltage responsivity of relay **205₁,205₂** due, for example, to relay **205₁,205₂** malfunctioning and/or wearing).

### Diagnosis Procedure

During the running of the diagnosis procedure, when the relay **205₁,205₂** has to be switched from the deactivated state to the activated state in order to identify the actual activation duty cycle value (and, hence, the actual minimum activation driving signal) to which the relay **205₁,205₂** is responsive, the control unit **210** selects (as discussed above, by properly setting the command signal *S_{COMM1},S_{COMM2}*) the relay **205₁,205₂** (preferably, one relay **205₁,205₂** at a time is selected) and a PWM signal *S_{PWM}* at the first reference duty cycle is first applied (and such as no activation driving signal *S_{ACT}* sufficient to switch the relay **205₁,205₂** into the activated state is originated). Thereafter, the control unit **210** is configured to increase the duty cycle of the PWM signal *S_{PWM}* from the first reference duty cycle value, and, for each duty cycle value (preferably, for each increase of value of the duty cycle), to sense the state of the selected relay **205₁,205₂.** Similarly to the above, the control unit **210** is configured to increase the duty cycle of the PWM signal *S_{PWM}* if, during sensing, the PWM signal *S_{PWM}* with the set duty cycle does not determine the switching of the selected relay **205₁** and/or **205₂** in the activated state (S*_{STATE1}*=S_{STATE,H} and/or S*_{STATE2}*=S_{STATE,H}, respectively). In other words, as long as the switching of the selected relay **205₁,205₂** into the activated state is not sensed, the control unit **210** increases the duty cycle of the PWM signal *S_{PWM},* and a new sensing is carried out.

Similarly, when the relay **205₁,205₂** has to be switched from the activated state to the deactivated state in order to identify the actual hold duty cycle value (and, hence, the actual minimum hold driving signal) to which the relay **205₁,205₂** is responsive, the control unit **210** selects (as discussed above, by properly setting the command signal *S_{COMM1},S_{COMM2}*) the relay **205₁,205₂** (preferably, one relay **205₁,205₂** at a time is selected) and a PWM signal *S_{PWM}* with duty cycle at the second reference duty cycle value is first applied (and such as no hold driving signal *S_{HOLD}* sufficient to switch the relay **205₁,205₂** into the deactivated state is originated). Thereafter, the control unit **210** is configured to decrease (*e.g.*, progressively decrease) the duty cycle of the PWM signal *S_{PWM}* from the second reference duty cycle value, and, for each duty cycle value (preferably, for each decrease of value of the duty cycle), to sense the state of the selected relay **205₁,205₂.** Thus, the control unit **210** is configured to decrease the value of the duty cycle of the PWM signal *S_{PWM}* if, during sensing, the PWM signal *S_{PWM}* with the set duty cycle value does not determine the switching of the selected relay **205₁** and/or **205₂** into the deactivated state (S*_{STATE1}*=S_{STATE,L} and/or S*_{STATE2}*=S_{STATE,L}, respectively). In other words, as long as the switching of the selected relay **205₁,205₂** into the deactivated state is not sensed, the control unit **210** decreases the value of the duty cycle of the PWM signal *S_{PWM},* and a new sensing is carried out.

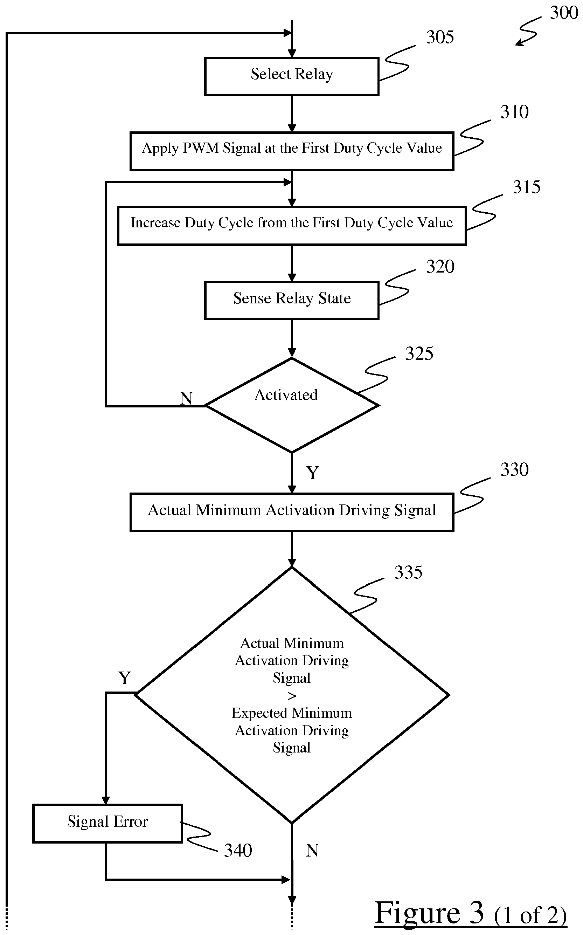

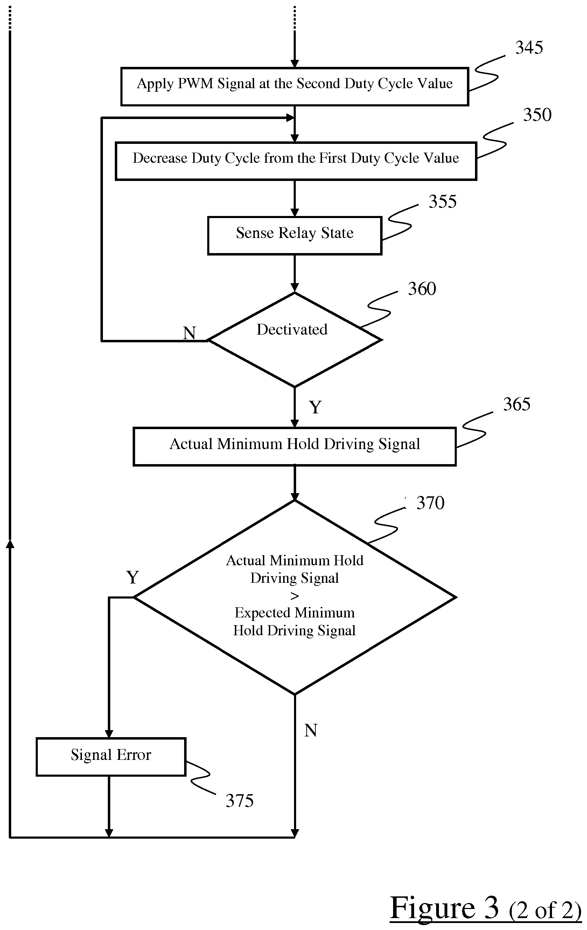

With joint reference now to **Figure 3****,** it shows a simplified flowchart of a diagnosis procedure **300** implemented by means the circuit system **200** according to an embodiment of the present invention. As a preliminary consideration, it is pointed out that the diagnosis procedure **300** is not strictly connected to the specific circuit system **200** implementation, the principles of the diagnosis procedure herein discussed being likely to be put into practice by means of any other circuit system implementation. However, the use of a same circuit system for both the execution of a treatment program and the running of the diagnosis procedure (as previously discussed) makes the design of the circuit system easy, and the costs and size thereof low.

As mentioned above, the diagnosis procedure **300** is preferably carried out during a manufacturing process and/or a servicing of the appliance **100.** When, as herein exemplary assumed, the diagnosis procedure **300** is controlled by the control unit **210** by invoking a corresponding instructions set stored therein upon reception of the diagnosis signal *S_{DIAG}* at the diagnosis pin, the diagnosis procedure **300** may also be carried out remotely by the appliance manufacturer (*e.g*., during a remote servicing) if the appliance **100** supports such a functionality.

During the manufacturing process of the appliance **100,** the identification of the actual minimum activation and hold driving signals to which each relay **205₁,205₂** is responsive may allow determining possible breakages and/or damages thereof either occurred during shipping of the PCB on which they are placed (in which case, the presence of a general damaging of the whole PCB could also be investigated) or due to relay **205₁,205₂** manufacturing defects (the cause of the breakages and/or damages being for example determined or inferred according to the identified actual minimum activation *S_{ACT}* and hold *S_{HOLD}* driving signals to which the relay **205₁,205₂** is responsive).

Instead, during the servicing, the identification of the actual minimum activation and hold driving signals to which each relay **205₁,205₂** is responsive may allow determining the aging thereof (in which case, a residual lifetime of each relay **205₁,205₂** can be estimated according to the identified actual minimum activation and hold driving signals to which the relay **205₁,205₂** is responsive, and, depending on the estimated residual lifetimes, it could be evaluated knowingly the convenience of replacing the whole PCB or of keeping the current PCB with modified activation *SACT* and hold *SHOLD* driving signals).

As visible in the activity diagram, the diagnosis procedure **300** starts by selecting the relay **205₁,205₂** whose operation has to be checked out (action node 305). Preferably, the diagnosis procedure **300** is carried out iteratively on one relay at a time (*i.e.,* at each iteration of the diagnosis procedure **300** only one relay **205₁,205₂** is selected). Moreover, as mentioned above, the diagnosis procedure **300** can be performed on a subset of the total number of relays **205₁,205₂** of the appliance **100,** instead of on the total number of relays **205₁,205₂.**

The selection of the relay **205₁,205₂** is preferably carried out by providing (by the control unit **115**) the command signal *S_{COMM1},S_{COMM2}* at the high logic level (or at the tristate logic level, according to the considered driving embodiment) to the driving arrangement (and, specifically, to the dedicated relay coil driver **220₁,220₂** associated with the relay **205₁,205₂** to be selected) and the command signal *S_{COMM1},S_{COMM2}* at the low logic level for all the other relays **205₁,205₂** (the command signal *S_{COMM1},S_{COMM2}* at the low logic level being for example the default condition).

Then, the diagnosis procedure **300** goes on by applying to the selected relay **205₁,205₂** the PWM signal *S_{PWM}* with duty cycle at the first reference duty cycle value (action node **310**). As discussed above, by design, with the PWM signal *S_{PWM}* at the first reference duty cycle value the selected relay **205₁,205₂** is in the deactivated state.

The diagnosis procedure **300** then goes on by (*e.g*., progressively) increasing the value of duty cycle of the PWM signal *S_{PWM}* from the first reference duty cycle value - action node **315,** this operation being preferably carried out, as discussed above, by the control unit **210** - and by sensing, at each duty cycle increase, the switching of the relay **205₁,205₂** into the activated state - action node **320,** this operation being preferably carried out, as discussed above, by the sensing arrangement **225_{1A},225_{1B},225_{2A},225_{2B}** and by the control unit **210** that processes the state signals *S_{STATE1},S_{STATE2}.*

The increase of the value of duty cycle is preferably performed by a predefined amount, *e.g*. by a predefined percentage/fraction of duty cycle. By way of example only, the duty cycle can be increased by 1 to 20% at a time, depending on the desired accuracy.

Back to diagnosis procedure **300,** a check is then performed at the decision node **325** aimed at determining whether the switching of the relay **205₁,205₂** into the activated state has occurred - this operation being preferably carried out, as discussed above, by the control unit **210** according to the state signal *S_{STATE1},S_{STATE2}* from the sensing arrangement **225_{1A},225_{1B},225_{2A},225_{2B}**. Thus, the increase of the value of duty cycle is preferably iterated until the switching of the relay **205₁,205₂** into the activated state is sensed, as conceptually illustrated in the figure by loop connection between the exit branch **N** of the decision node **325** (indicating that no switching of the selected relay **205₁,205₂** into the activated state has occurred) and the action node **315.**

As should be readily understood, the operative loop **315-325** may also include further decision and/or action nodes - for example, a further check could be carried out for determining whether the current value of duty cycle, *i.e.* the value of duty cycle after increase, has reached or substantially reached 100% without that any switching is sensed, which would be indicative of a relay **205₁,205₂** damaging.

As soon as the switching of the relay **205₁,205₂** into the activated state is sensed (exit branch **Y** of the decision node **325**), the value of duty cycle at which the switching has been sensed is identified (*e.g.,* by the control unit **210**) as the actual activation duty cycle value (corresponding to the actual minimum activation driving signal) to which the relay **205₁,205₂** is responsive (action node **330**), thereafter an error for the selected relay **205₁,205₂** is signaled (action node **340**) if (exit branch **Y** of the decision node **335**) the actual minimum activation driving signal is higher than a respective expected minimum activation driving signal to which the selected relay **205₁,205₂** is expected, by design, to be responsive (*i.e*., at the decision node **335** a comparison is performed between the actual minimum activation driving signal for the selected relay **205₁,205₂** and the respective expected minimum activation driving signal).

According to an embodiment of the present invention, said error signaling for the selected relay **205₁,205₂** comprises displaying an indication of the error (*e.g.,* an alphanumeric code attributable to the error, or a message directly describing the error) on a display, not shown, of the appliance **100.** Additionally or alternatively, said error signaling may comprise emitting sound and/or light alarms.

Preferably, as mentioned above, said error signaling for the selected relay **205₁,205₂** further comprises providing an estimate of a residual lifetime of the selected relay **205₁,205₂** based on the actual minimum activation driving signal just determined, so that, depending on the estimated residual lifetime, an operator can evaluate knowingly the convenience of replacing the whole PCB or of keeping the current PCB with modified activation and hold driving signals. As an example, when the diagnosis procedure **300** is carried out during appliance **100** manufacturing, when the residual lifetime of the selected relay **205₁,205₂** is estimated to be two years or less, it could be convenient to replace the PCB (so as to reduce as much as possible the number of appliances still under warranty that need to be repaired or replaced). As a further example, when the diagnosis procedure **300** is carried out during either a manufacturing and/or a servicing of the appliance **100,** when the residual lifetime of the selected relay **205₁,205₂** is estimated to be relatively long (such as two years or more), it could be convenient keep the current PCB and to set the activation duty cycle value of each relay **205₁,205₂** (*i.e.,* the duty cycle value by which each relay **205₁,205₂** is controlled/driven during normal operation, when the appliance **100** is installed in the user premise and executes the conventional treatment programs desired by the user) at the duty cycle corresponding to the respective actual minimum activation driving signal (*i.e.,* the duty cycle determined by the diagnosis procedure **300**).

The estimate of the residual lifetime of the selected relay **205₁,205₂** is preferably carried out by the control unit **210,** even more preferably based on one or more look up tables stored therein that put the percentage difference between the actual minimum activation driving signal to which the selected relay **205₁,205₂** is actually responsive and the respective expected minimum activation driving signal to which the selected relay **205₁,205₂** is expected, by design, to be responsive in association with the estimated lifetime of that relay **205₁,205₂** (this look up tables being preferably made available by the electronics supplier).

Back to the activity diagram, if the actual minimum activation driving signal for the selected relay **205₁,205₂** is equal to (or substantially matches) the respective expected minimum activation driving signal (exit branch **N** of the decision node **335**), the diagnosis procedure **300** goes on by checking (nodes **345-375**) the actual minimum hold signal for the same relay **205₁,205₂** - however, as illustrated in the figure, the actual minimum hold signal for the relay **205₁,205₂** is preferably checked even if a signal error for the same relay **205₁,205₂** has been sensed due to the actual minimum activation driving signal (see connection between the action node **340** and the action node **345**). According to alternative embodiments of the present invention, not shown, the diagnosis procedure **300** ends, for the selected relay **205₁,205₂,** after an error about the minimum activation driving signal has been detected and signaled (*i.e.,* after the action node **340**), and the diagnosis procedure **300** so far discussed is iterated in a similar way for each other relay **205₁,205₂** of the subset of relays to be checked.

Moreover, the checking of the actual minimum activation driving signal (nodes **305-340**) and of the actual minimum hold driving signal (nodes **345-375**) is not necessarily made in the order herein discussed - with the checking of the actual minimum hold driving signal that may for example be performed before the checking of the actual minimum activation driving signal. In addition, according to alternative embodiments of the present invention, only the actual minimum activation driving signal or the actual minimum hold driving signal may be checked.

Back to the illustrated embodiment, the diagnosis procedure **300** goes on by applying (by means of the control unit **210**) to the selected relay **205₁,205₂** the PWM signal *S_{PWM}* with the duty cycle at the second reference duty cycle value (action node **345**), and to the driving arrangement (and, specifically, to the dedicated relay coil driver **220₁,220₂** associated with the selected relay **205₁,205₂**) the command signal *S_{COMM1},S_{COMM2}* at the tristate logic level. As discussed above, by design, with the duty cycle at the second reference duty cycle value the selected relay **205₁,205₂** is in the activated state.

The second reference duty cycle value is advantageously higher than the first reference duty cycle value. More advantageously, the second reference duty cycle value is 100%, so as to almost certainly ensure relay **205₁,205₂** activation (thereby "compensating" the absence of the high logic level of the command signal *S_{COMM1},S_{COMM2}* that, by superimposition to the PWM signal *S_{PWM},* contributes to the relay **205₁,205₂** activation when checking the actual minimum activation driving signal).

Similarly to the above, the diagnosis procedure **300** goes on by (*e.g,* progressively) decreasing the value of duty cycle of the PWM signal *S_{PWM}* from the second reference duty cycle value - action node **350,** this operation being preferably carried out, as discussed above, by the control unit **210** - and by sensing, at each duty cycle decrease, the switching of the relay **205₁,205₂** into the deactivated state - action node **355,** this operation being preferably carried out, as discussed above, by the sensing arrangement **225_{1A},225_{1B},225_{2A},225_{2B}** and by the control unit **210** that receives the corresponding state signal *S_{STATE1},S_{STATE2}.*

The decrease of value of the duty cycle is preferably performed by a predefined amount, *e.g*. by a predefined percentage/fraction of duty cycle. By way of example only, the duty cycle can be increased by 1 to 20% at a time, depending on the desired accuracy. According to specific design options, not limiting for the present invention, the increase and decrease duty cycle percentages may also differ from each other.

Back to the diagnosis procedure **300**, a check is then performed at the decision node **360** aimed at determining whether the switching of the relay **205₁,205₂** into the deactivated state has occurred - similarly to the above, this operation being preferably carried out by the control unit **210** according to the state signal *S_{STATE1},S_{STATE2}* from the sensing arrangement **225_{1A},225_{1B},225_{2A},225_{2B}**. Thus, the decrease of the value of duty cycle is preferably iterated until the switching of the relay **205₁,205₂** into the deactivated state is sensed, as conceptually illustrated in the figure by loop connection between the exit branch **N** of the decision node **360** and the action node **350.**

As should be readily understood, the operative loop **350-360** may also include further decision and/or action nodes - for example, a further check could be carried out for determining whether the current value of duty cycle, *i.e.* the duty cycle after decrease, is relatively close to 100% (*e.g*., between 90% and 99%), which would be indicative of a relay **205₁,205₂** damaging or of an excessive aging.

As soon as the switching of the relay **205₁,205₂** into the deactivated state is sensed (exit branch **Y** of the decision node **360**), the value of duty cycle at which the switching has been sensed is identified (*e.g*., by the control unit **210**) as the actual hold duty cycle value (corresponding to the actual minimum hold driving signal) to which the relay **205₁,205₂** is responsive (action node **365**), thereafter an error for the selected relay **205₁,205₂** is signaled (action node **375**) if (exit branch **Y** of the decision node **370**) the actual minimum hold driving signal is higher than a respective expected minimum hold driving signal to which the selected relay **205₁,205₂** is expected, by design, to be responsive (*i.e*., at the decision node **370** a comparison is performed between the actual minimum activation driving signal for the selected relay **205₁,205₂** and the respective expected minimum activation driving signal).

As discussed above, said error signaling for the selected relay **205₁,205₂** comprises displaying an indication of the error (*e.g.,* an alphanumeric code attributable to the error or a message directly describing the error on the display of the appliance **100,** or sound and/or light indications).

Preferably, as mentioned above, said error signaling for the selected relay **205₁,205₂** further comprises providing an estimate of a residual lifetime of the selected relay **205₁,205₂** based on the actual minimum hold driving signal just determined (and, even more preferably, also based on the actual minimum activation driving signal), so that, depending on the estimated residual lifetime, an operator can evaluate knowingly the convenience of replacing the whole PCB or of keeping the current PCB with modified activation and hold driving signals. Referring back to the examples of above, when the residual lifetime of the selected relay **205₁,205₂** is estimated to be two years or less, it could be convenient to replace the PCB, whereas when the residual lifetime of the selected relay **205₁,205₂** is estimated to be relatively long, it could be convenient to keep the current PCB set the hold duty cycle value of each relay **205₁,205₂** at the value of duty cycle corresponding to the respective actual minimum hold driving signal just determined.

Similarly to the above, the estimate of the residual lifetime of the selected relay **205₁,205₂** is preferably carried out by the control unit **210,** even more preferably based on one or more look up tables stored therein that put the percentage difference between the actual minimum activation and/or hold driving signals to which the selected relay **205₁,205₂** is actually responsive and the respective expected minimum activation and/or hold driving signals to which the selected relay **205₁,205₂** is expected, by design, to be responsive in association with the estimated lifetime of that relay **205₁,205₂.**

Back to the decision node **370,** if the actual minimum hold driving signal sensed for the selected relay **205₁,205₂** is not higher than the respective expected minimum hold driving signal, and, hence, no error for the selected relay **205₁,205₂** is signaled for the minimum hold driving signal, the diagnosis procedure **300** so far discussed is iterated in a similar way for each other relay **205₁,205₂** of the subset of relays to be checked (as conceptually represented in the figure by loop connection between the exit branch **N** of the decision node **370** and the action node **305.** Preferably, as illustrated by connection between the action node **375** and the action node **305,** the diagnosis procedure **300** is iterated for the other relays **205₁,205₂** even after an error about the minimum hold driving signal has been detected and signaled for the selected relay **205₁,205₂** - so as to have a more complete indication of PCB damaging and/or possible damaging over time.

With respect to the prior-art solutions, which allow determining relay malfunctioning only after the appliance has been installed in the user premises and contextually to the execution of the treatment programs, the present invention allows easily and correctly diagnosing the relays of the appliance during any suitable phase of the appliance life, such as during appliance manufacturing and/or during appliance servicing. This is achieved by means of the same circuit system that is used for controlling relay activation and deactivation during normal operation of the appliance (*e.g*., during execution of a treatment program required by the user), which makes the design of the circuit system easy, and the costs and size thereof low.

Thanks to the advanced diagnosis provided by the discussed diagnosis, correct and efficient control of relay activation and deactivation is ensured during execution of a treatment program, *i.e.* when the appliance is installed in the user premises and operated by the user. Indeed, any uncertainty is avoided about the actual driving signals to which each relay is responsive for switching it into the activation or hold phases, so that the risk that appliance delivered to the user (after buying or servicing it) has defective relays is drastically reduced.

Naturally, in order to satisfy local and specific requirements, a person skilled in the art may apply to the invention described above many logical and/or physical modifications and alterations. More specifically, although the invention has been described with a certain degree of particularity with reference to preferred embodiments thereof, it should be understood that various omissions, substitutions and changes in the form and details as well as other embodiments are possible, being the scope of protection defined in the appended claims.

## Claims

1. Method (**300**) for diagnosing an electric appliance (**100**), the electric appliance (**100**) comprising at least one electromechanical component (**205₁,205₂**) each one being switchable between deactivated and activated states for selectively coupling and decoupling electric loads to respective supply sources of the appliance (100) thereby allowing electric load energization and de-energization, respectively, for each selected electromechanical component (**205₁,205₂**) the method being **characterized by** comprising:
applying (**310,345**) to the selected electromechanical component (**205₁,205₂**) a PWM signal having a duty cycle whose value is at a reference duty cycle value,
varying (**315,350**) the value of duty cycle of the PWM signal from the reference duty cycle value,
sensing (**320,355**) the switching of the selected electromechanical component (**205₁,205₂**), the value of duty cycle at which the switching of the selected electromechanical component (**205₁,205₂**) has been sensed corresponding to an actual minimum driving signal to which the selected electromechanical component (**205₁,205₂**) is responsive,
comparing (**335,370**) the actual minimum driving signal of the selected electromechanical component (**205₁,205₂**) to a respective expected minimum driving signal to which the selected electromechanical component (**205₁,205₂**) is expected, by design, to be responsive, and
signaling (**340,375**) an error of the selected electro-mechanical component (**205₁,205₂**) if (**335,370**) the actual minimum driving signal is higher than the respective expected minimum driving signal.

2. Method (**300**) according to Claim 1, wherein the reference duty cycle value comprises a first reference duty cycle value and the actual minimum driving signal comprises an actual minimum activation driving signal to which the selected electromechanical component (**205₁,205₂**) is responsive for activation, and wherein:
said applying (**310,345**) comprises applying (**310**) to the selected electromechanical component (**205₁,205₂**) a PWM signal having a duty cycle whose value is at the first reference duty cycle value, with the first reference duty cycle value the selected electromechanical component (**205₁,205₂**) being in the deactivated state,
said varying (**315,350**) comprises increasing (**315**) the value of duty cycle of the PWM signal from the first reference duty cycle value,
said sensing (**320,355**) comprises sensing (**320**) the switching of the selected electromechanical component (**205₁,205₂**) into the activated state, the value of duty cycle at which the switching of the selected electromechanical component (**205₁,205₂**) has been sensed corresponding to the actual minimum activation driving signal of the selected electromechanical component (**205₁,205₂**),
said comparing (**335,370**) comprises comparing (**335**) the actual minimum activation driving signal of the selected electromechanical component (**205₁,205₂**) to a respective expected minimum activation driving signal to which the selected electromechanical component (**205₁,205₂**) is expected, by design, to be responsive, for activation, and
said signaling (**340,375**) comprises signaling (**340**) an error of the selected electro-mechanical component (**205₁,205₂**) if (**335**) the actual minimum activation driving signal is higher than the respective expected minimum activation driving signal.

3. Method (**300**) according to Claim 1 or 2, wherein the reference duty cycle value comprises a second reference duty cycle value, and the actual minimum driving signal comprises an actual minimum hold driving signal at which the selected electromechanical component (**205₁,205₂**) is still held in the activated state, and wherein:
said applying (**310,345**) comprises applying (**345**) to the selected electromechanical component (**205₁,205₂**) a PWM signal having a duty cycle whose value is at the second reference duty cycle value, with the second reference duty cycle value the selected electromechanical component (**205₁,205₂**) being in the activated state,
said varying (**315,350**) comprises decreasing (**350**) the value of duty cycle of the PWM signal from the second reference duty cycle value,
said sensing (**320,355**) comprises sensing (**355**) the switching of the selected electromechanical component (**205₁,205₂**) into the deactivated state, the value of duty cycle at which the switching of the selected electromechanical component (**205₁,205₂**) has been sensed corresponding to the actual minimum hold driving signal of the selected electromechanical component (**205₁,205₂**),
said comparing (**335,370**) comprises comparing (**370**) the actual minimum hold driving signal of the selected electromechanical component (**205₁,205₂**) to a respective expected minimum hold driving signal at which the selected electromechanical component (**205₁,205₂**) is expected, by design, to be still held in the activated state, and
said signaling (**340,375**) comprises signaling (**375**) an error of the selected electro-mechanical component (**205₁,205₂**) if (**370**) the actual minimum hold driving signal is higher than the respective expected minimum hold driving signal.

4. Method (**300**) according to Claim 3 when depending on Claim 2, wherein said applying (**345**) to the selected electromechanical component (**205₁,205₂**) a PWM signal having a duty cycle whose value is at the second reference duty cycle value is carried out after said comparing (**335**) the actual minimum activation driving signal of the selected electromechanical component (**205₁,205₂**) to the respective expected minimum activation driving signal.

5. Method (**300**) according to Claim 2, 3 or 4, wherein the second duty cycle value is higher than the value of duty cycle corresponding to the actual minimum activation driving signal of the selected electromechanical component (**205₁,205₂**).

6. Method (**300**) according to any of the preceding Claims, wherein said signaling (**340,375**) an error of the selected electromechanical component (**205₁,205₂**) comprises providing an estimate of a residual lifetime of the selected electromechanical component (**205₁,205₂**) based on the actual minimum driving signal thereof.

7. Method according to any Claim from 3 to 6 when depending on Claim 3, wherein said signaling (**340,375**) an error of the selected electromechanical component (**205₁,205₂**) comprises providing an estimate of a residual lifetime of the selected electromechanical component (**205₁,205₂**) based on at least one between the actual minimum activation driving signal and the actual minimum hold driving signal thereof.

8. Method (**300**) according to any Claim from 2 to 7 when depending on Claim 2, wherein said increasing (**315**) comprises progressively increasing the value of duty cycle of the PWM signal from the first reference duty cycle value, and wherein said sensing (**320**) the switching of the selected electromechanical component (**205₁,205₂**) into the activated state is performed at each increase, the method (**300**) further comprising repeating said increasing (**315**) and said sensing (**320**) until (**325**) the switching of the selected electromechanical component (**205₁,205₂**) into the activated state is sensed.

9. Method (**300**) according to any Claim from 3 to 8 when depending on Claim 3, wherein said decreasing (**350**) comprises progressively decreasing the value of duty cycle of the PWM signal from the second reference duty cycle value, and wherein said sensing (**355**) the switching of the selected electromechanical component (**205₁,205₂**) into the deactivated state is performed at each decrease, the method (**300**) further comprising repeating said decreasing (**350**) and said sensing (**355**) until (**360**) the switching of the selected electromechanical component (**205₁,205₂**) into the deactivated state is sensed.

10. Method (**300**) according to any of the preceding Claims, wherein said signaling (**340,375**) an error of the selected electromechanical component (**205₁,210₂**) comprises displaying an indication of the error and/or emitting sound and/or light alarms.

11. Method (**300**) according to Claim 10, wherein said indication of the error comprises at least one between an alphanumeric code attributable to the error and a message directly describing the error.

12. Method (**300**) according to any of the preceding Claims, wherein the method (**300**) is carried out during a manufacturing process and/or a servicing of the electric appliance (**100**).

13. Method (**300**) according to any of the preceding Claims, wherein said at least one electromechanical component (**205₁,205₂**) comprises at least one relay (**205₁,205₂**).

14. Method (**300**) according to any of the preceding Claims, wherein the electric appliance (**100**) is a laundry washing appliance, a laundry drying appliance, or a laundry washing and drying appliance.

## Patentansprüche

1. Verfahren (300) zum Diagnostizieren eines elektrischen Geräts (100), wobei das elektrische Gerät (100) mindestens eine elektromechanische Komponente (205₁, 205₂) umfasst, die jeweils zum wahlweisen Koppeln und Entkoppeln von elektrischen Lasten mit jeweiligen Stromversorgungsquellen des Geräts (100) zwischen deaktivierten und aktivierten Zuständen umschaltbar sind, wodurch das Versorgen der elektrischen Last mit Energie bzw. das Beenden des Versorgens der elektrischen Last mit Energie für jede ausgewählte elektromechanische Komponente (205₁, 205₂) ermöglicht wird, wobei das Verfahren **gekennzeichnet ist durch**:
Anlegen (310, 345) eines PWM-Signals mit einer Impulsperiode, deren Wert bei einem Referenzimpulsperiodenwert liegt, an die ausgewählte elektromechanische Komponente (205₁, 205₂),
Verändern (315, 350) des Wertes der Impulsperiode des PWM-Signals vom Referenzimpulsperiodenwert,
Erfassen (320, 355) des Umschaltens der ausgewählten elektromechanischen Komponente (205₁, 205₂), wobei der Wert der Impulsperiode, bei der das Umschalten der ausgewählten elektromechanischen Komponente (205₁, 205₂) erfasst worden ist, einem tatsächlichen, minimalen Ansteuersignal entspricht, auf das die ausgewählte elektromechanische Komponente (205₁, 205₂) antwortet,
Vergleichen (335, 370) des tatsächlichen, minimalen Ansteuersignals der ausgewählten elektromechanischen Komponente (205₁, 205₂) mit einem jeweiligen erwarteten, minimalen Ansteuersignal, wobei gemäß der Konstruktion erwartet wird, dass die ausgewählte elektromechanische Komponente (205₁, 205₂) darauf antwortet, und
Signalisieren (340, 375) eines Fehlers der ausgewählten elektromechanischen Komponente (205₁, 205₂), wenn (335, 370) das tatsächliche, minimale Ansteuersignal höher als das jeweilige erwartete, minimale Ansteuersignal ist.

2. Verfahren (300) nach Anspruch 1, wobei der Referenzimpulsperiodenwert einen ersten Referenzimpulsperiodenwert umfasst und das tatsächliche, minimale Ansteuersignal ein tatsächliches, minimales Aktivierungsansteuersignal, auf das die ausgewählte elektromechanische Komponente (205₁, 205₂) zur Aktivierung antwortet, umfasst, und wobei:
das Anlegen (310, 345) das Anlegen (310) eines PWM-Signals mit einer Impulsperiode, deren Wert bei dem ersten Referenzimpulsperiodenwert liegt, an die ausgewählte elektromechanische Komponente (205₁, 205₂) umfasst, wobei sich die ausgewählte elektromechanische Komponente (205₁, 205₂) mit dem ersten Referenzimpulsperiodenwert im deaktivierten Zustand befindet,
das Verändern (315, 350) das Erhöhen (315) des Wertes der Impulsperiode des PWM-Signals vom ersten Referenzimpulsperiodenwert umfasst,
das Erfassen (320, 355) das Erfassen (320) des Umschaltens der ausgewählten elektromechanischen Komponente (205₁, 205₂) in den aktivierten Zustand umfasst, wobei der Wert der Impulsperiode, bei dem das Umschalten der ausgewählten elektromechanischen Komponente (205₁, 205₂) erfasst worden ist, dem tatsächlichen, minimalen Aktivierungsansteuersignal der ausgewählten elektromechanischen Komponente (205₁, 205₂) entspricht,
das Vergleichen (335, 370) das Vergleichen (335) des tatsächlichen, minimalen Aktivierungsansteuersignals der ausgewählten elektromechanischen Komponente (205₁, 205₂) mit einem jeweiligen erwarteten, minimalen Aktivierungsansteuersignal, wobei gemäß der Konstruktion erwartet wird, dass die elektromechanische Komponente (205₁, 205₂) zur Aktivierung darauf antwortet, umfasst, und
das Signalisieren (340, 375) das Signalisieren (340) eines Fehlers der ausgewählten elektromechanischen Komponente (205₁, 205₂), wenn (335) das tatsächliche, minimale Aktivierungsansteuersignal höher als das jeweilige erwartete, minimale Aktivierungsansteuersignal ist.

3. Verfahren (300) nach Anspruch 1 oder 2, wobei der Referenzimpulsperiodenwert einen zweiten Referenzimpulsperiodenwert umfasst und das tatsächliche, minimale Ansteuersignal ein tatsächliches, minimales Halteansteuersignal, bei dem die ausgewählte elektromechanische Komponente (205₁, 205₂) weiterhin im aktivierten Zustand gehalten wird, umfasst, und wobei:
das Anlegen (310, 345) das Anlegen (345) eines PWM-Signals mit einer Impulsperiode, deren Wert bei dem zweiten Referenzimpulsperiodenwert liegt, an die ausgewählte elektromechanische Komponente (205₁, 205₂) umfasst, wobei sich die ausgewählte elektromechanische Komponente (205₁, 205₂) mit dem zweiten Referenzimpulsperiodenwert im aktivierten Zustand befindet,
das Verändern (315, 350) das Absenken (350) des Wertes der Impulsperiode des PWM-Signals vom zweiten Referenzimpulsperiodenwert umfasst,
das Erfassen (320, 355) das Erfassen (355) des Umschaltens der ausgewählten elektromechanischen Komponente (205₁, 205₂) in den deaktivierten Zustand umfasst, wobei der Wert der Impulsperiode, bei der das Umschalten der ausgewählten elektromechanischen Komponente (205₁, 205₂) erfasst worden ist, dem tatsächlichen, minimalen Halteansteuersignal der ausgewählten elektromechanischen Komponente (205₁, 205₂) entspricht,
das Vergleichen (335, 370) das Vergleichen (370) des tatsächlichen, minimalen Halteansteuersignals der ausgewählten elektromechanischen Komponente (205₁, 205₂) mit einem jeweiligen erwarteten, minimalen Halteansteuersignal, für das gemäß der Konstruktion erwartet wird, dass die ausgewählte elektromechanische Komponente (205₁, 205₂) weiterhin im aktivierten Zustand gehalten wird, umfasst, und
das Signalisieren (340, 375) das Signalisieren (375) eines Fehlers der ausgewählten elektromechanischen Komponente (205₁, 205₂), wenn (370) das tatsächliche, minimale Halteansteuersignal höher als das jeweilige erwartete, minimale Halteansteuersignal ist.

4. Verfahren (300) nach Anspruch 3, wenn abhängig von Anspruch 2, wobei das Anlegen (345) eines PWM-Signals mit einer Impulsperiode, deren Wert bei dem zweiten Referenzimpulsperiodenwert liegt, an die ausgewählte elektromechanische Komponente (205₁, 205₂) nach dem Vergleichen (335) des tatsächlichen, minimalen Aktivierungsansteuersignals der ausgewählten elektromechanischen Komponente (205₁, 205₂) mit dem jeweiligen erwarteten, minimalen Aktvierungsansteuersignal ausgeführt wird.

5. Verfahren (300) nach Anspruch 2, 3 oder 4, wobei der zweite Impulsperiodenwert höher als der Wert der Impulsperiode, der dem tatsächlichen, minimalen Aktivierungsansteuersignal der ausgewählten elektromechanischen Komponente (205₁, 205₂) entspricht, ist.

6. Verfahren (300) nach einem der vorhergehenden Ansprüche, wobei das Signalisieren (340, 375) eines Fehlers der ausgewählten elektromechanischen Komponente (205₁, 205₂) das Bereitstellen eines Schätzwertes einer Restlebensdauer der ausgewählten elektromechanischen Komponente (205₁, 205₂) auf der Grundlage ihres tatsächlichen, minimalen Ansteuersignals umfasst.

7. Verfahren nach einem der Ansprüche von 3 bis 6, wenn von Anspruch 3 abhängig, wobei das Signalisieren (340, 375) eines Fehlers der ausgewählten elektromechanischen Komponente (205₁, 205₂) das Bereitstellen eines Schätzwertes einer Restlebensdauer der ausgewählten elektromechanischen Komponente (205₁, 205₂) auf der Grundlage ihres tatsächlichen, minimalen Aktivierungsansteuersignals und/oder ihres tatsächlichen, minimalen Halteansteuersignals umfasst.

8. Verfahren (300) nach einem der Ansprüche von 2 bis 7, wenn von Anspruch 2 abhängig, wobei das Erhöhen (315) das progressive Erhöhen des Wertes der Impulsperiode des PWM-Signals vom ersten Referenzimpulsperiodenwert umfasst und wobei das Erfassen (320) des Umschaltens der ausgewählten elektromechanischen Komponente (205₁, 205₂) in den aktivierten Zustand bei jeder Erhöhung durchgeführt wird, wobei das Verfahren (300) ferner das Wiederholen des Erhöhens (315) und des Erfassens (320), bis (325) das Umschalten der ausgewählten elektromechanischen Komponente (205₁, 205₂) in den aktivierten Zustand erfasst wird, umfasst.

9. Verfahren (300) nach einem der Ansprüche von 3 bis 8, wenn von Anspruch 3 abhängig, wobei das Absenken (350) das progressive Absenken des Wertes der Impulsperiode des PWM-Signals vom zweiten Referenzimpulsperiodenwert umfasst und wobei das Erfassen (355) des Umschaltens der ausgewählten elektromechanischen Komponente (205₁, 205₂) in den deaktivierten Zustand bei jedem Absenken durchgeführt wird, wobei das Verfahren (300) ferner das Wiederholen des Absenkens (350) und des Erfassens (355), bis (360) das Umschalten der ausgewählten elektromechanischen Komponente (205₁, 205₂) in den deaktivierten Zustand erfasst wird, umfasst.

10. Verfahren (300) nach einem der vorhergehenden Ansprüche, wobei das Signalisieren (340, 375) eines Fehlers der ausgewählten elektromechanischen Komponente (205₁, 205₂) das Anzeigen einer Angabe des Fehlers und/oder das Emittieren eines Tonalarms und/oder eines Lichtalarms umfasst.

11. Verfahren (300) nach Anspruch 10, wobei die Angabe des Fehlers einen alphanummerischen Code, der dem Fehler zugewiesen werden kann, und/oder eine Nachricht, die den Fehler direkt beschreibt, umfasst.

12. Verfahren (300) nach einem der vorhergehenden Ansprüche, wobei das Verfahren (300) während eines Herstellungsprozesses und/oder einer Wartung des elektrischen Geräts (100) ausgeführt wird.

13. Verfahren (300) nach einem der vorhergehenden Ansprüche, wobei die mindestens eine elektromechanische Komponente (205₁, 205₂) mindestens ein Relais (205₁, 205₂) umfasst.

14. Verfahren (300) nach einem der vorhergehenden Ansprüche, wobei das elektrische Gerät (100) ein Gerät zum Waschen von Wäsche, ein Gerät zum Trocknen von Wäsche oder ein Gerät zum Waschen und Trocknen von Wäsche ist.

## Revendications

1. Procédé (**300**) de diagnostic d'un appareil électrique (**100**), l'appareil électrique (**100**) comprenant au moins un composant électromécanique (**205₁**, **205₂**) dont chacun est commutable entre des états désactivé et activé pour sélectivement coupler et découpler des charges électriques à des sources d'alimentation respectives de l'appareil (100) en permettant ainsi respectivement l'excitation et la désexcitation des charges électriques pour chaque composant électromécanique (**205₁**, **205₂**) sélectionné, le procédé étant **caractérisé en ce qu'**il comprend :
l'application (**310**, **345**), au composant électromécanique (**205₁**, **205₂**) sélectionné, d'un signal PWM possédant un rapport cyclique dont la valeur est à une valeur de référence de rapport cyclique,
la variation (**315**, **350**) de la valeur de rapport cyclique du signal PWM par rapport à la valeur de référence de rapport cyclique,
la détection (**320**, **355**) de la commutation du composant électromécanique (**205₁**, **205₂**) sélectionné, la valeur de rapport cyclique à laquelle la commutation du composant électromécanique (**205₁**, **205₂**) sélectionné a été détectée correspondant à un signal d'attaque minimal effectif auquel le composant électromécanique (**205₁**, **205₂**) sélectionné réagit,
la comparaison (**335**, **370**) du signal d'attaque minimal effectif du composant électromécanique (**205₁**, **2052**) sélectionné à un signal d'attaque minimal prévu respectif auquel il est prévu que le composant électromécanique (**205₁**, **205₂**) sélectionné, de par sa conception, réagisse, et
la signalisation (**340**, **375**) d'une erreur du composant électromécanique (**205₁**, **205₂**) sélectionné si **(335, 370)** le signal d'attaque minimal effectif est plus élevé que le signal d'attaque minimal prévu respectif.

2. Procédé (**300**) selon la revendication 1, dans lequel la valeur de référence de rapport cyclique comprend un première valeur de référence de rapport cyclique et le signal d'attaque minimal effectif comprend un signal d'attaque d'activation minimal effectif auquel le composant électromécanique (**205₁**, **2052**) sélectionné réagit pour s'activer, et dans lequel :
ladite application (**310, 345**) comprend l'application (**310**), au composant électromécanique (**205₁**, **2052)** sélectionné, d'un signal PWM possédant un rapport cyclique dont la valeur est à la première valeur de référence de rapport cyclique, avec la première valeur de référence de rapport cyclique le composant électromécanique (**205₁**, **205₂)** sélectionné étant à l'état désactivé,
ladite variation **(315, 350)** comprend l'augmentation **(315)** de la valeur de rapport cyclique du signal PWM à partir de la première valeur de référence de rapport cyclique,
ladite détection **(320, 355)** comprend la détection **(320)** de la commutation du composant électromécanique (**205₁**, **205₂**) sélectionné sur l'état activé, la valeur de rapport cyclique à laquelle la commutation du composant électromécanique (**205₁**, **205₂)** sélectionné a été détectée correspondant au signal d'attaque d'activation minimal effectif du composant électromécanique (**205₁**, **205₂)** sélectionné,
ladite comparaison (**335, 370**) comprend la comparaison (**335**) du signal d'attaque d'activation minimal effectif du composant électromécanique (**205₁**, **205₂)** sélectionné à un signal d'attaque d'activation minimal prévu respectif auquel il est prévu que le composant électromécanique (**205₁**, **205₂)** sélectionné, de par sa conception, réagisse pour s'activer, et
ladite signalisation (**340, 375**) comprend la signalisation (**340**) d'une erreur du composant électromécanique (**205₁**, **205₂)** sélectionné si (**335**) le signal d'attaque d'activation minimal effectif est plus élevé que le signal d'attaque d'activation minimal prévu respectif.

3. Procédé (**300**) selon la revendication 1 ou 2, dans lequel la valeur de référence de rapport cyclique comprend une deuxième valeur de référence de rapport cyclique, et le signal d'attaque minimal effectif comprend un signal d'attaque de maintien minimal effectif auquel le composant électromécanique (**205₁**, **205₂**) sélectionné continue d'être maintenu à l'état activé, et dans lequel :
ladite application (**310, 345**) comprend l'application (**345**), au composant électromécanique (**205₁**, **205₂)** sélectionné, d'un signal PWM possédant un rapport cyclique dont la valeur est à la deuxième valeur de référence de rapport cyclique, avec la deuxième valeur de référence de rapport cyclique le composant électromécanique (**205₁**, **205₂**) sélectionné étant à l'état activé,
ladite variation (**315, 350**) comprend la diminution **(350)** de la valeur de rapport cyclique du signal PWM à partir de la deuxième valeur de référence de rapport cyclique,
ladite détection (**320, 355**) comprend la détection **(355)** de la commutation du composant électromécanique (**205₁**, **205₂**) sélectionné sur l'état désactivé, la valeur de rapport cyclique à laquelle la commutation du composant électromécanique (**205₁**, **205₂)** sélectionné a été détectée correspondant au signal d'attaque de maintien minimal effectif du composant électromécanique (**205₁**, **205₂**) sélectionné,
ladite comparaison (**335, 370**) comprend la comparaison (**370**) du signal d'attaque de maintien minimal effectif du composant électromécanique (**205₁**, **205₂)** sélectionné à un signal d'attaque de maintien minimal prévu respectif auquel il est prévu que le composant électromécanique (**205₁**, **205₂**) sélectionné, de par sa conception, continue de se maintenir à l'état activé, et
ladite signalisation (**340**, **375**) comprend la signalisation (**375**) d'une erreur du composant électromécanique (**205₁**, **205₂**) sélectionné si (**370**) le signal d'attaque de maintien minimal effectif est plus élevé que le signal d'attaque de maintien minimal prévu respectif.

4. Procédé (**300**) selon la revendication 3 lorsqu'elle dépend de la revendication 2, dans lequel ladite application (**345**), au composant électromécanique (**205₁**, **205₂**) sélectionné, d'un signal PWM possédant un rapport cyclique dont la valeur est à la deuxième valeur de référence de rapport cyclique est réalisée après ladite comparaison (**335**) du signal d'attaque d'activation minimal effectif du composant électromécanique (**205₁**, **205₂**) sélectionné au signal d'attaque d'activation minimal prévu respectif.

5. Procédé (**300**) selon la revendication 2, 3 ou 4, dans lequel la deuxième valeur de référence de rapport cyclique est plus élevée que la valeur de rapport cyclique correspondant au signal d'attaque d'activation minimal effectif du composant électromécanique (**205₁**, **205₂**) sélectionné.

6. Procédé (**300**) selon l'une quelconque des revendications précédentes, dans lequel ladite signalisation (**340**, **375**) d'une erreur du composant électromécanique (**205₁**, **205₂**) sélectionné comprend la fourniture d'une estimation d'une durée de vie résiduelle du composant électromécanique (**205₁**, **205₂**) sélectionné sur la base de son signal d'attaque minimal effectif.

7. Procédé selon l'une quelconque des revendications 3 à 6 lorsqu'elle dépend de la revendication 3, dans lequel ladite signalisation (**340, 375**) d'une erreur du composant électromécanique (**205₁**, **205₂**) sélectionné comprend la fourniture d'une estimation d'une durée de vie résiduelle du composant électromécanique (**205₁**, **205₂**) sélectionné sur la base de son signal d'attaque d'activation minimal effectif et/ou de son signal d'attaque de maintien minimal effectif.

8. Procédé (**300**) selon l'une quelconque des revendications 2 à 7 lorsqu'elle dépend de la revendication 2, dans lequel ladite augmentation (**315**) comprend l'augmentation progressive de la valeur de rapport cyclique du signal PWM à partir de la première valeur de référence de rapport cyclique, et dans lequel la détection (**320**) de la commutation du composant électromécanique (**205₁**, **205₂**) sélectionné sur l'état activé est exécutée à chaque augmentation, le procédé (**300**) comprenant en outre la répétition de ladite augmentation (**315**) et de ladite détection (**320**) jusqu'à (**315**) la détection de la commutation du composant électromécanique (**205₁**, **205₂**) sélectionné sur l'état activé.

9. Procédé (**300**) selon l'une quelconque des revendications 3 à 8 lorsqu'elle dépend de la revendication 3, dans lequel ladite diminution (**350**) comprend la diminution progressive de la valeur de rapport cyclique du signal PWM à partir de la deuxième valeur de référence de rapport cyclique, et dans lequel la détection (**355**) de la commutation du composant électromécanique (**205₁**, **205₂**) sélectionné sur l'état désactivé est exécutée à chaque diminution, le procédé (**300**) comprenant en outre la répétition de ladite diminution (**350**) et de ladite détection (**355**) jusqu'à (**360**) la détection de la commutation du composant électromécanique (**205₁, 205₂**) sélectionné sur l'état désactivé.

10. Procédé (**300**) selon l'une quelconque des revendications précédentes, dans lequel ladite signalisation (**340, 375**) d'une erreur du composant électromécanique (**205₁, 205₂**) sélectionné comprend l'affichage d'une indication de l'erreur et/ou l'émission d'alarmes sonores et/ou lumineuses.

11. Procédé (**300**) selon la revendication 10, dans lequel ladite indication de l'erreur comprend un code alphanumérique attribuable à l'erreur et/ou un message décrivant directement l'erreur.

12. Procédé (**300**) selon l'une quelconque des revendications précédentes, lequel procédé (**300**) est réalisé au cours d'un processus de fabrication et/ou d'un entretien de l'appareil électrique (**100**).

13. Procédé (**300**) selon l'une quelconque des revendications précédentes, dans lequel ledit au moins un composant électromécanique (**205₁, 205₂**) comprend au moins un relais (**205₁, 205₂**).

14. Procédé (**300**) selon l'une quelconque des revendications précédentes, dans lequel l'appareil électrique (**100**) est un appareil à laver le linge, un appareil à sécher le linge ou un appareil à laver et sécher le linge.
